# EUROPEAN PATENT SPECIFICATION

(11) **EP 0 868 704 B1**
(45) Date of publication and mention of the grant of the patent: **06.10.1999**
(21) Application number: 96943749.0
(22) Date of filing: 17.12.1996
(51) Int. Cl.: G06K 7/00, G06K 7/06, G06K 19/073

(54) **FAULT DETECTION AND MODIFICATION CIRCUIT**
FEHLERERKENNUNGS- UND SIGNALABÄNDERUNGSSCHALTUNG
CIRCUIT DE MODIFICATION ET DE DETECTION DE DEFAILLANCES

(30) Priority: 22.12.1995 US 9178 P; 02.01.1996 GB 9600002; 28.06.1996 GB 9613608
(43) Date of publication of application: 07.10.1998
(73) Proprietor: THOMSON CONSUMER ELECTRONICS, INC., Indianapolis, IN 46290-1024 (US)
(72) Inventor: PITSCH, Robert, Alan, Indianapolis, IN 46236 (US)
(74) Representative: Rossmanith, Manfred, Dr.
(86) International application number: PCT/US96/19928
(87) International publication number: WO 97/23840

(56) References cited:
- EP-A- 0 265 312
- EP-A- 0 341 712
- EP-A- 0 363 871
- PATENT ABSTRACTS OF JAPAN vol. 12, no. 173 (P-706), 24 May 1988 & JP 62 282389 A (TOSHIBA CORP.), 8 December 1987,
- PATENT ABSTRACTS OF JAPAN vol. 11, no. 153 (P-577), 19 May 1987 & JP 61 289480 A (SANKYO SEIKI MFG CO.,LTD), 19 December 1986,
- PATENT ABSTRACTS OF JAPAN vol. 14, no. 369 (P-1090), 9 September 1990 & JP 02 135589 A (OMRON TATEISI ELECTRON CO.), 24 May 1990,

## Description

The present invention relates generally to access control systems including an integrated circuit (IC) card, or "smart" card, for limiting access to information in signal processing application. More particularly, the present invention relates to a smart card reader operation when a fault is detected.

Systems such as pay-TV systems include access control sub-systems that limit access to certain programs or channels. Only users who are entitled (e.g., paid a fee) are permitted to view the programs.

Access control systems may include an integrated circuit (IC) card, or "smart" card, feature. A smart card is a plastic card the size of a credit card that has a signal processing IC embedded in the plastic. A smart card is inserted into a smart card reader that couples signals to and from the IC in the card. The IC in a smart card processes data such as security control information as part of an access control protocol. The IC includes a control microcomputer, such as the 6805 processor from Motorola Semiconductor, Austin, Texas, which includes ROM, EEPROM, and RAM memory. The processor performs various security control functions including entitlement management and generating a key for descrambling the scrambled data component of the signal.

Sometimes, the various contacts on the smart card may be shorted together by debris or by malfunctioning of the smart card circuitries. For example, debris can accumulate on the contacts of a smart card during manufacturing, shipment, user replacement or wiping action of the smart card. This shorting of the smart card contacts will, in turn, short the smart card power supply or present a low impedance to the power supply, causing it to go into a current limiting condition. If the signals to the card are not turned off or modified immediately, large current from the control lines could be coupled into the smart card, causing destruction. This may damage the circuitries in both the smart card and the smart card reader.

EP-A-0 363 871 discloses a smart card reader comprising control means having a signal line for providing a control signal to a smart card; detection means, independently of said control means, for detecting when a supply voltage provided to said smart card drops below a reference voltage. Similar readers are also known from JP-A-61 289 480 and JP-A-62 282 389.

In accordance with an aspect of the present invention, a circuit is provided to detect when a variation in a power supply coupled to a smart card reader has occurred, indicating a possible fault in the smart card (e.g., shorted contacts or other malfunctions). As an example, the circuit detects this variation by comparing the voltage coupled to smart card with a reference voltage. If the circuit detects that the voltage has dropped below the reference voltage, it will modify the smart card control signals, by clamping them at or near ground potential. This prevents any potential damage to either the smart card or the smart card reader. The invention is set forth in claims 1 and 6.

The invention may be better understood by referring to the accompanying drawing in which:

Figure 1A shows the physical layout of the contacts of an exemplary smart card as defined by the current ISO standard 7816.

Figure 1B shows the contact and signal assignments of an exemplary smart card as defined by the current ISO standard 7816.

Figure 2 shows an exemplary embodiment of the current invention as employed in a smart card reader.

Figure 3 shows another embodiment of the present invention using Field Effective Transistors (FETs).

Figure 4 shows another embodiment of the present invention using transmission gates to isolate the control lines to the smart card.

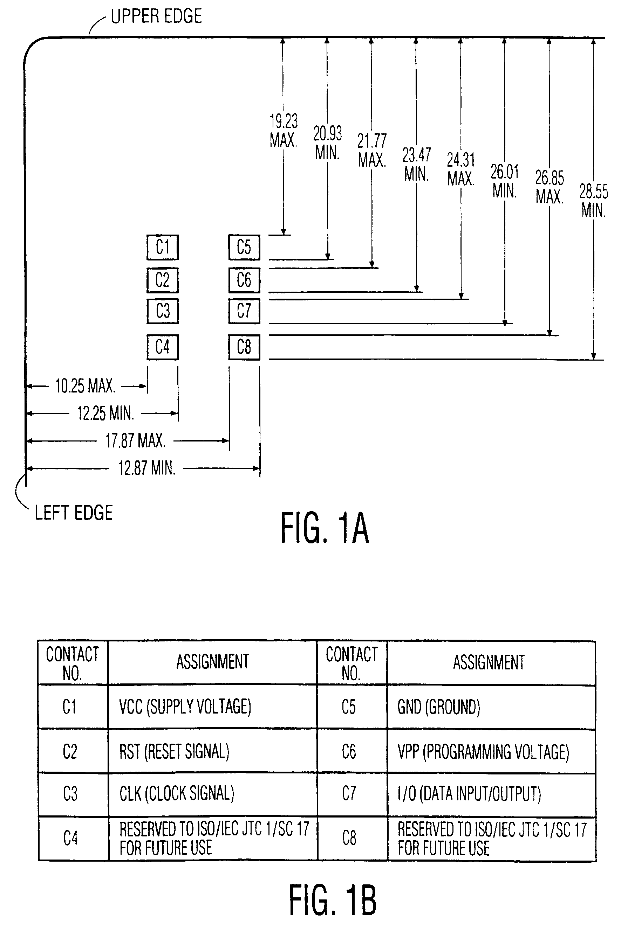

International Standards Organization (ISO) standard 7816 establishes specifications for a smart card interface. In particular, the ISO standard 7816-2 specifies that the electrical interface to the card will be via eight contacts positioned on the card surface as shown in Figure 1A. Six of the eight signals at the contact points are defined as Vcc (supply voltage), RST (reset signal), CLK (clock signal), GND (ground), Vpp (programming voltage for programming memory in the card IC), and I/O (serial data input/output). Two contacts are reserved for future use. The assignment of the signals to the smart card contacts is shown in Figure 1B.

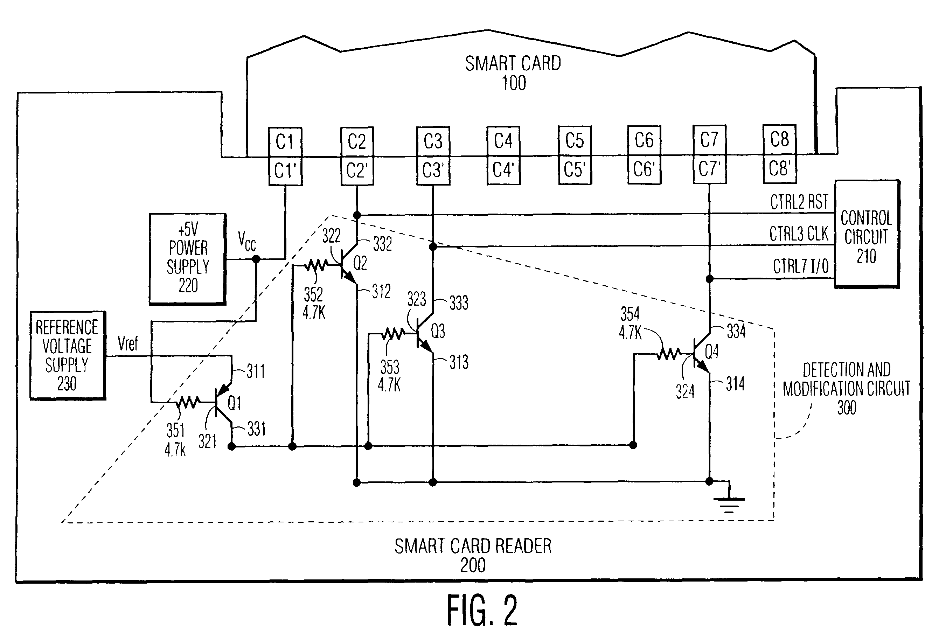

Figure 2 shows an exemplary embodiment of the present invention. An ISO 7816 compliant smart card 100 having eight contacts C1 - C8 is shown coupled to and communicating with a smart card reader 200. Again, the definitions and assignments of the contacts C1 - C8 of the smart card 100 are shown in Fig. 1B.

The smart card reader 200 illustrated in Fig. 2 also has eight contacts C1' - C8', which have the same assignments and definitions as shown in Fig. 1B. In particular, contact C1' of the smart card reader 200 is the Vcc contact for providing a power supply voltage to the smart card. In the present exemplary embodiment. the power supply is a regulated +5 V supply 220.

In addition, contacts C2', C3' and C7' are presented with respective control signals RST, CLK and I/O data from a control circuit 210. These control signals pass to or from the contacts via control lines CTRL2, CTRL3, and CTRL7. The control circuit 210 under the supervision of a microprocessor (not shown) selectively provides the proper signals to the smart card, according to the desired application and design requirements. For example, when necessary, the microprocessor may command the control circuit 210 to send a reset signal RST through the control line CTRL2 to contact C2'. This would allow the smart card 100 to be reset. Note that although only three control lines are shown in Fig. 2 for illustrative purposes, one skilled in the art can readily appreciate that additional control lines may be similarly utilized in the future for conducting signals to or from the smart card 100.

The detection and modification circuit 300 of the present invention comprises a detection transistor Q1. Q1 in the present embodiment is a PNP bipolar transistor such as a 2N3906 transistor made by Motorola. The emitter terminal 311 of Q1 is connected to a reference voltage supply 230. In this embodiment, the reference voltage is pre-calibrated to have the same potential as the Vcc supply voltage, +5v. The base terminal 321 of Q1 is connected to one end of a 4.7 KOhm base resistor, 351. The other end of the resistor 351 is connect to the output Vcc of the power supply 220. This allows detection transistor Q1 to monitor the power supply 220 as will be made clear later.

Each of the control lines CTRL2, CTRL3, and CTRL7 is connected respectively to one of the collector terminals 332-334 of clamping transistors Q2, Q3 and Q4. The clamping transistors Q2, Q3, and Q4 in the present embodiment are NPN bipolar transistors such as model BC546B made by Motorola. Each of the base terminals 322-324 of the clamping transistors Q2-Q4 are each coupled to one end of a 4.7 KOhm resistor 352-353. The other ends of the resistors 352-353 are connected to the collector terminal 331 of the detection transistor Q1. All of the emitter terminals of Q2-Q4 are grounded.

The function of the detection and shut down circuit 300 will now be described. The function of the detection portion of the circuit 300 is to detect a variation of the supply voltage Vcc. It has been recognized by the inventor that when a short or current limiting condition exists in the power supply of the smart card reader, the output voltage will vary. In particular, the output will drop below the normally intended Vcc (i.e., +5V in our embodiment). Q1, in our example, is constantly monitoring the Vcc output at its base terminal 321. When the voltage output Vcc drops more than .6 volt below the preselected reference voltage, transistor Q1 will turn on.

Once transistor Q1 turns on, current also flows through the base terminals 322-324 of clamping transistors Q2-Q4 in the modification portion of the circuit 300. This will in turn cause each of the clamping transistors Q2-Q4 to turn on, thereby clamping the control lines CTRL2, CTRL3 and CTRL7 to be at or near ground potential (i.e., Vce saturation voltage, typically at .005 - .2 v). This modifies the voltages on the control lines and effectively shut them down, thus preventing any potential damage to any circuitries in either the smart card or the smart card reader.

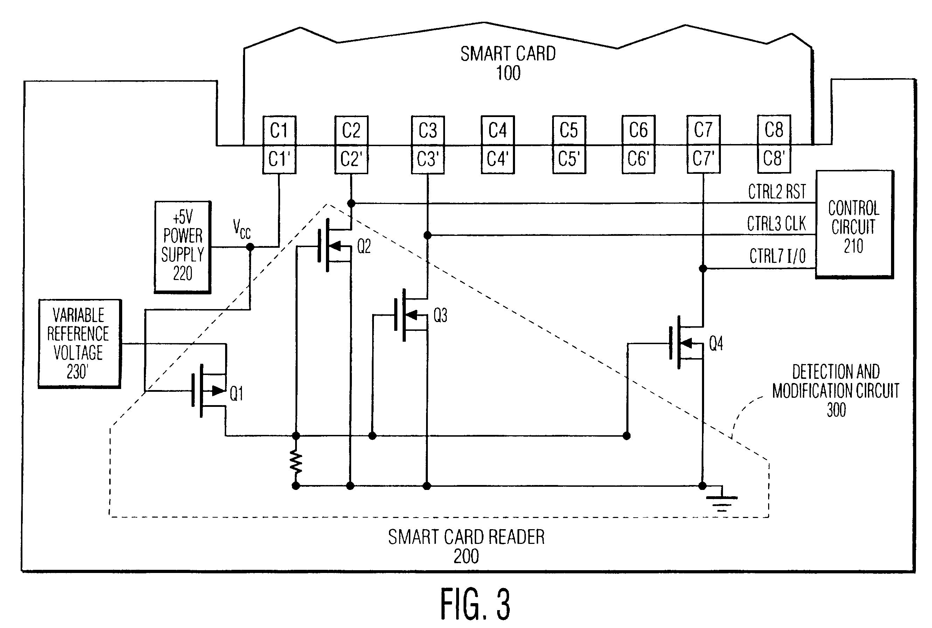

Fig. 3 shows another embodiment of the present invention. In this embodiment, the detection and modification circuit 300 comprises Field Effective Transistors (FETs), instead of bipolar transistors. This embodiment is especially advantageous if circuit 300 is implemented as a part of an Integrated Circuit (IC). In addition, the reference voltage supply 230' shown in Fig. 3 is now variably adjustable. This allows an user to adjust, depending on the design requirements, the reference voltage at which the detection transistor Q1 and the clamping transistors Q2-Q4 will be turned on.

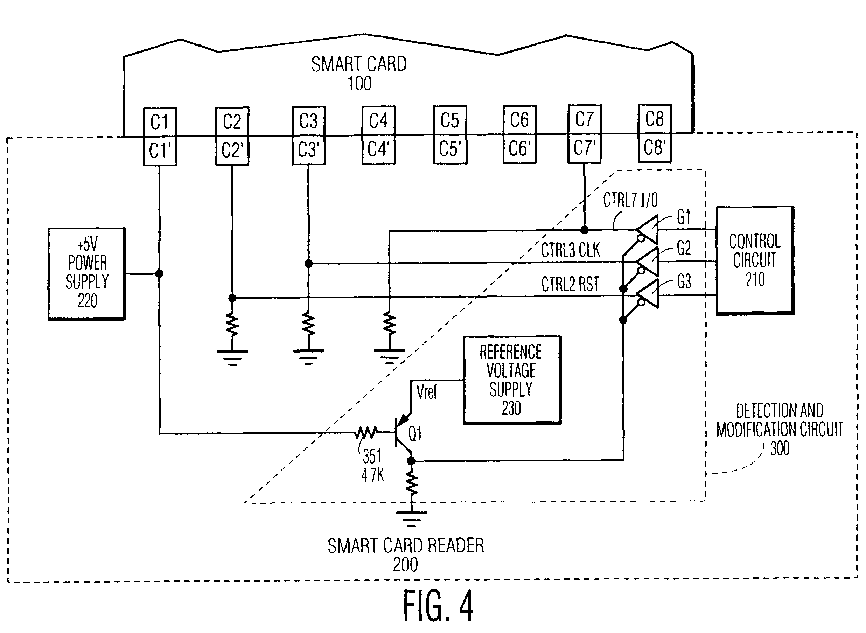

Fig. 4 shows another embodiment of the present invention. In this embodiment, the modification portion of the circuit 300 comprises transmission gates G1-G3. These transmission gates G1-3 are controlled by detection transistor Q1. When Q1 detects that the power supply 220 drops below a reference voltage Vref, Q1 will cause the transmission gates G1-G3 to isolate the control signals from the contacts C2', C3' and C7'.

It will be apparent to those skilled in the art, that although the invention has been described in terms of specific examples, modifications and changes may be made to the disclosed embodiments without departing from the invention. For example, although the present invention is described mainly using ISO complaint embodiments, it can clearly be employed in any smart card related systems, include a non-standard system. It is, therefore, to be understood, that the appended claims are intended to cover all modifications which naturally flow from the foregoing treatise and examples.

## Claims

1. A smart card reader comprising:
control means having a signal line for providing a control signal to a smart card;
detection means, independent of said control means, for detecting a variation in a supply voltage provided to said smart card; characterized by
clamping means coupled to said signal line, for clamping said signal line to substantially ground potential, without intervention of said control means when said detection means determines that said supply voltage drops below a reference voltage.

2. The smart card reader of claim 1, wherein said reference voltage is preset to approximately said supply voltage, and said clamping means is activated when said supply voltage drops V_{be} below the reference voltage.

3. The smart card reader of claim 1 wherein said clamping means is coupled to said detection means.

4. The smart card reader of claim 3 wherein said claimping means comprises a transistor.

5. The smart card reader of claim 4, wherein said detection means comprises a transistor.

6. A method of protecting a smart card by a smart card reader, comprising the steps of:
providing a pularity of control signals via a signal line to said smart card from a control means;
detecting, independent of said control means, a variation in a supply voltage provided to said smart card;
clamping said signal line to substantially ground potential, without intervention of said control means, when said detection means determines that said supply voltage drops below a reference voltage.

7. The method of claim 6, wherein said detecting step further comprising the step of preseting said refcrence voltage to approximately one V_{be} voltage drop from said supply voltage.

## Patentansprüche

1. Smart Card-Leser, enthaltend:
Steuermittel mit einer Signalleitung zum Liefern eines Steuersignals an eine Smart Card,
Detektiermittel, unabhängig von den Steuermitteln, zum Detektieren einer Änderung in einer der Smart Card zugeführten Betriebsspannung, gekennzeichnet durch mit der Signalleitung verbundene Klemmittel zum Klemmen der Signalleitung im wesentlichen auf Erdpotential ohne Eingriff der Steuermittel, wenn die Detektiermittel feststellen, daß die Betriebsspannung unter eine Referenzspannung abfällt.

2. Smart Card-Leser nach Anspruch 1, wobei die Referenzspannung etwa auf die Betriebsspannung voreingestellt ist und die Klemmittel betätigt werden, wenn die Betriebsspannung unter die Referenzspannung Vbe abfällt.

3. Smart Card-Leser nach Anspruch 1, wobei die Klemmittel mit den Detektiermitteln verbunden sind.

4. Smart Card-Leser nach Anspruch 3, wobei die Klemmittel einen Transistor enthalten.

5. Smart Card-Leser nach Anspruch 4, wobei die Detektiermittel einen Transistor enthalten.

6. Verfahren zum Schutz einer Smart Card durch einen Smart Card-Leser, enthaltend folgende Schritte:
Liefern von mehreren Steuersignalen von Steuermitteln über eine Signalleitung zu der Smart Card,
Detektieren, unabhängig von den Steuermitteln, einer Änderung in einer für die Smart Card vorgesehenen Betriebsspannung,
Klemmen der Signalleitung etwa auf Erdpotential, ohne Eingriff der Steuermittel, wenn die Detektiermittel feststellen, daß die Betriebsspannung unter eine Referenzspannung abfällt.

7. Verfahren nach Anspruch 6, wobei der Schritt zum Detektieren außerdem den Schritt enthält, die Referenzspannung auf ungefähr einen Spannungsabfall Vbe der Betriebsspannung voreinzustellen.

## Revendications

1. Un lecteur de cartes à puce comprenant :
des moyens de commande comportant une ligne de signal pour fournir un signal de commande à une carte à puce ;
des moyens de détection, indépendants des moyens de commande, pour détecter une variation dans la tension d'alimentation fournie à ladite carte à puce; caractérisé par
des moyens de verrouillage couplés à ladite ligne de signal, pour verrouiller ladite ligne de signal à un potentiel sensiblement égal à celui de la masse, sans intervention dudit moyen de commande, lorsque lesdits moyens de détection déterminent que la tension d'alimentation chute en dessous d'une tension de référence.

2. Le lecteur de cartes à puce de la revendication 1, dans lequel ladite tension de référence est préréglée à approximativement ladite tension d'alimentation, et ledit moyen de verrouillage est activé lorsque ladite tension d'alimentation chute de Vbe en dessous de la tension de référence.

3. Le lecteur de cartes à puce de la revendication 1, dans lequel ledit moyen de verrouillage est couplé audit moyen de détection.

4. Le lecteur de cartes à puce de la revendication 3, dans lequel ledit moyen de verrouillage comporte un transistor.

5. Le lecteur de cartes à puce de la revendication 4, dans lequel ledit moyen de détection comporte un transistor.

6. Un procédé de protection d'une carte à puce par un lecteur de cartes à puce, comportant les étapes de :
fournir une pluralité de signaux de commande à travers une ligne de signal à ladite carte à puces à partir d'un moyen de commande ;
détecter, indépendamment dudit moyen de commande, une variation dans la tension d'alimentation fournie à ladite carte à puce ;
verrouiller ladite ligne de signal à un potentiel sensiblement égal à la masse, sans intervention dudit moyen de commande, lorsque ledit moyen de détection détermine que ladite tension d'alimentation chute en-dessous d'une tension de référence.

7. Le procédé de la revendication 6, dans lequel ladite étape de détection comporte de plus une étape de préréglage de la tension de référence à approximativement une chute de tension de V_{be} à partir de ladite tension d'alimentation.
